# EUROPEAN PATENT APPLICATION

(11) **EP 2 392 690 A1**
(43) Date of publication of application: **07.12.2011**
(21) Application number: 10164534.9
(22) Date of filing: 31.05.2010
(51) Int. Cl.: C23C 14/14, C23C 14/35, A01N 59/16, A01N 59/20

(54) **Antibacterial alloy coating composition**

(71) Applicant: Industrial Technology Research Institute, Chu-Tung, Hsinchu (TW)
(72) Inventor: Yang, Chih-Chao, Tainan City (TW)
(74) Representative: Viering, Jentschura & Partner

(57) **Abstract**

An antibacterial alloy coating composition is applied to a surface of a device. The composition comprises an antibacterial material and an alloy. The alloy consists of more than four metallic elements and at least one non-metallic element. The antibacterial material is, for example, copper, silver, or a combination thereof, and the atomic percentage content thereof is 1.7% to 26.8% of the total content. These metallic elements are selected from the group consisting of iron, cobalt, chromium, nickel, aluminum, vanadium, and titanium. The non-metallic element is selected from the group consisting of boron, oxygen, and nitrogen.

## Description

### BACKGROUND OF THE INVENTION

### Field of Invention

The present invention relates to an alloy coating, and more particularly to an antibacterial alloy coating composition.

### Related Art

With the economic development and the improvement of the life quality, people pay more attention to cleaning and hygiene. Hygienic requirements increase gradually for the devices used in daily life (such as kitchen wares and hygienic facilities), especially for the medical supplies for which the hygienic requirements are very high. In various items of cleaning and hygiene, the antimicrobial activity has become one of the important indicator items of cleaning and hygiene. Thus, there does exist a need for the devices with antibacterial functions in the present life.

For the supplies with antibacterial functions on the market at present, the surfaces of the supplies are generally coated with a layer of a material with antibacterial property, for example, which may be an inorganic compound, organic compound, or natural antibacterial agent. However, such a material with antibacterial property has poor adhesion, so that when these supplies are subjected to brushing, solarization, friction, or even heating and drying etc. for several times, the antibacterial materials on the surfaces of the supplies will scale off gradually, and it can well be imagined the antibacterial abilities of the materials will decrease significantly or even disappear completely. Thus, the antibacterial functions are lost.

Therefore, the technical persons in the related field at present are intended to solve the problem of developing a material with both high antimicrobial activity and long-time antibacterial property.

### SUMMARY OF THE INVENTION

The present invention provides an antibacterial alloy coating composition, whereby the requirements of both high antimicrobial activity.

The present invention discloses an antibacterial alloy coating composition. The antibacterial alloy coating composition comprises an antibacterial material and an alloy, and the alloy consists of at least more than four metallic elements and at least one non-metallic element. The antibacterial material is, for example, copper or silver, and the atomic percentage content thereof is about 1.7% to 26.8% of the total content. These metallic elements mentioned above are selected from the group consisting of iron, cobalt, chromium, nickel, aluminum, vanadium, and titanium, and the non-metallic element is selected from the group consisting of boron, oxygen, and nitrogen. Next, the atomic percentage content of the foregoing alloy is about 73.2% to 98.3% of the total content.

Thus, the antibacterial alloy coating composition disclosed in the present invention has an excellent antibacterial effect indeed, its antimicrobial activity is up to 5.2, and its antimicrobial percentage is also up to more than 99.6%. Further, the hardness of the antibacterial alloy coating prepared from the antibacterial alloy coating composition of the present invention can also be up to more than about 10 Gpa. It can be known from this, utilizing the antibacterial alloy coating composition with special formulation of the present invention to be coated on the hygienic or medical devices, not only the hardness of these devices is increased, but also the antibacterial effect on the surfaces of the devices is improved, thereby the application of the devices can be enhanced.

The foregoing description related to the content of the invention and the following description for the embodiments of the invention are used to demonstrate and explain the principle of the present invention, and provide a further explanation for the claims of the present invention.

### BRIEF DESCRIPTION OF THE DRAWINGS

The present invention will become more fully understood from the detailed description given herein below for illustration only, and thus are not limitative of the present invention, and wherein:
FIG. 1 is an X-ray diffraction spectrum of the antibacterial alloy coating in embodiment 1 of the present invention;
FIG. 2 is an X-ray diffraction spectrum of the antibacterial alloy oxide coating in embodiment 2 of the present invention; and
FIG. 3 is an X-ray diffraction spectrum of the antibacterial alloy nitride coating in embodiment 3 of the present invention.

### DETAILED DESCRIPTION OF THE INVENTION

The antibacterial alloy coating composition of the present invention is applied to a surface of a device. A method for applying an antibacterial alloy on the surface of the device, such as coating or painting, firstly utilizes a process such as vacuum arc melting process or high frequency melting process to melt or synthesize a target, subsequently the target is subjected to a coating process such as vacuum sputtering process or vacuum arc ion plating process, but the method is not limited to this. The described device may be, for example, a dishware, knife tool, hygienic device, or medical device, and the material of the device may be, but are not limited to, metal, ceramic, plastic, glass etc.. The present invention is illustrated by way of the vacuum arc melting process and the vacuum sputtering process, and the device selected is a stainless steel substrate.

Further, the antibacterial alloy coating composition disclosed in the present invention comprises an antibacterial material and an alloy, and the alloy consists of at least more than four metallic elements and at least one non-metallic element. The antibacterial material is, for example, copper or silver, and the atomic percentage content thereof is about 1.7% to 26.8% of the total content. The metallic elements are selected from the group consisting of iron, cobalt, chromium, nickel, aluminum, vanadium, and titanium, and the non-metallic element is selected from the group consisting of boron, oxygen, and nitrogen. Next, the atomic percentage content of the foregoing metal alloy is 73.2% to 98.3% of the total content, the atomic percentage content of the metallic elements are 65.2% to 98% of the total content, and the atomic percentage content of the non-metallic element is 0.3% to 16.7% of the total content.

Hereinafter, the antibacterial alloy coating compositions of the present invention are described in detail by various embodiments, and their coating properties and antibacterial effect are discussed where the antibacterial alloy coating compositions in these embodiments are coated on the surfaces of the devices. Table 1 shows the antibacterial alloy coating compositions in the various embodiments, in which different antibacterial materials and alloys are used respectively, and these materials and alloys are mixed in different proportions.

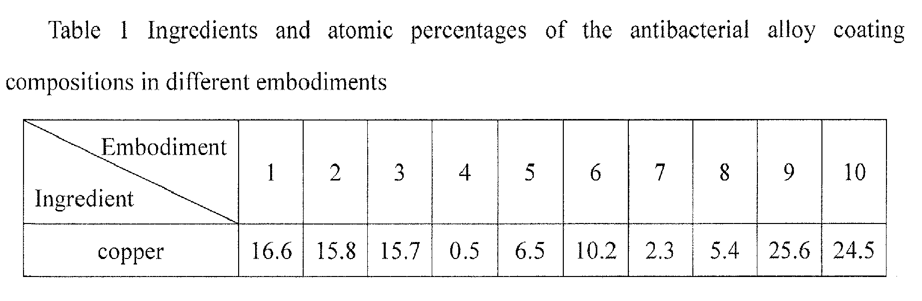

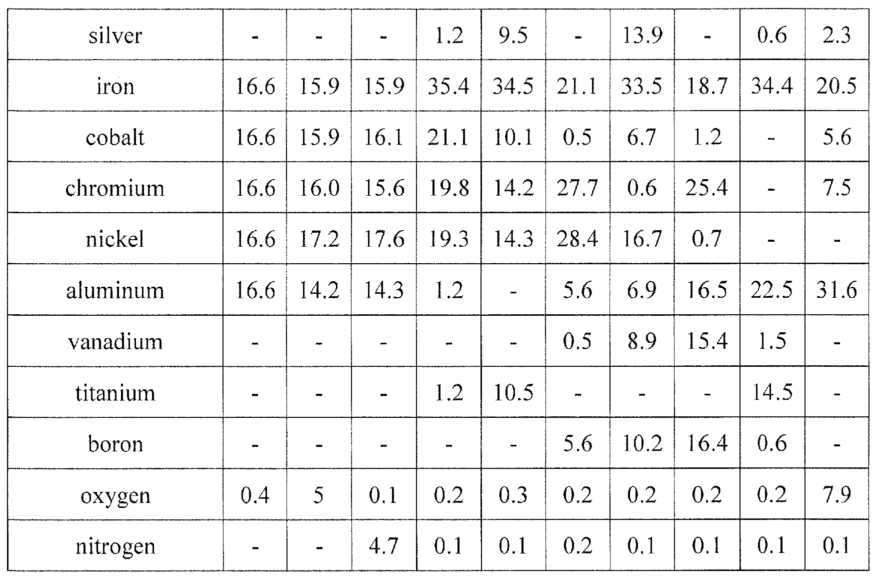

### Embodiment 1

In this embodiment 1, the antibacterial material in the antibacterial alloy coating composition is copper, and the metallic elements in the alloy consist of five metallic elements of aluminum, cobalt, chromium, iron, and nickel. As shown in table 1 above, the atomic percentage content of copper is 16.6%, and the atomic percentage contents of iron, cobalt, chromium, nickel, and aluminum are sequentially 16.6%, 16.6%, 16.6%, 16.6%, and 16.6%. Moreover, as shown in table 1, this embodiment further comprises minor non-metallic element, for example, 0.4% oxygen.

Firstly, an antibacterial alloy coating composition was formulated in the foregoing proportion. Thereafter, a target was prepared by a vacuum arc melting process. Before performing the vacuum arc melting process, a stainless steel substrate to be coated was subjected to a washing process to remove impurities on the surface of the stainless steel substrate. Then, the formulated antibacterial alloy coating composition was placed in a water cooled copper mold for arc melting and solidification, re-melted repeatedly for several times to allow these ingredients to be mixed homogeneously, and finally solidified to form a calce-like ingot. The cake-like ingot was machined to form a target. In other words, the target was a target of the antibacterial alloy coating composition. Thereafter, the target was placed on a RF magnetron sputter and subjected to a vacuum sputtering process for film coating on the surface of the stainless steel substrate. The film coating process was operated under a pressure of 1 x 10⁻⁴ Torr and at a temperature of 200□, and the coating time was about 20 minutes. Thus, an antibacterial alloy coating was formed on the surface of the stainless steel substrate. The thickness of the antibacterial alloy coating was 10 nm to 2,000 mn.

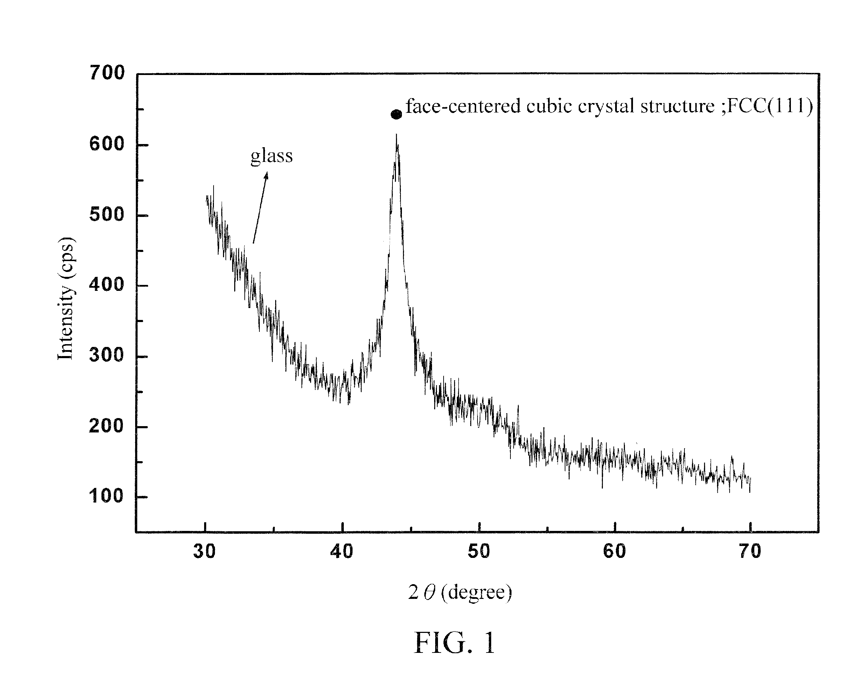

Then, an analysis for the coating property of the antibacterial alloy coating was performed on the surface of the stainless steel substrate, and the result is shown in FIG. 1.

FIG. 1 is an X-ray diffraction spectrum of the antibacterial alloy coating in embodiment 1 of the present invention. As known from the analytical result, the antibacterial alloy coating has a face-centered cubic (FCC) crystal structure. Subsequently, the hardness of the antibacterial alloy coating was tested by a scratch hardness test, and as known from the test result, the hardness of the antibacterial alloy coating prepared in embodiment 1 is 8.6 Gpa.

Further, the antibacterial alloy coating was subjected to an antibacterial experiment. Table 2 shows the antibacterial analytical values of the antibacterial alloy coating prepared in embodiment 1 of the present invention. As known from the result of the antibacterial experiment in table 2, for *staphylococcus aureus, E. coli, Klebsiella pneumoniae,* and *pseudomonas aeruginosa,* the antimicrobial activity of the antibacterial alloy coating is up to 5.2, and the antimicrobial percentage is also up to more than 99.999%. Therefore, the coating of the antibacterial alloy coating composition of the present invention has a very good antibacterial effect on the surface of the device indeed.

**Table 2 Antibacterial analytical values of the antibacterial alloy coating prepared in embodiment 1**

| Bacteria species | Control group Bacteria number after 24 h | Sample group Bacteria number after 24 h | antimicrobial activity | antimicrobial percentage (%) |
|---|---|---|---|---|
| *staphylococcus aureus* | 2.1x10⁶ | <10 | 5.32 | >99.999 |
| *E. coli* | 1.1 x 10⁶ | <10 | 5.04 | >99.999 |
| *Klebsiella pneumoniae* | 1.6 x 10⁶ | <10 | 5.20 | >99.999 |
| *pseudomonas aeruginosa* | 1.9 x10⁶ | <10 | 6.28 | >99.9999 |

### Embodiment 2

In this embodiment 2, the antibacterial material in the antibacterial alloy coating composition is copper, and the metallic elements in the alloy consist of five metallic elements of iron, cobalt, chromium, nickel, and aluminum. As shown in table 1 above, the atomic percentage content of copper is 15.8%, and the atomic percentage contents of iron, cobalt, chromium, nickel, and aluminum are sequentially 15.9%. 15.9%. 16.0%, 17.2%, and 14.2%. Moreover, as shown in table 1, this embodiment further comprises minor non-metallic element, for example, oxygen. In particular, the difference between embodiment 2 and embodiment 1 is only in that, when carrying out the vacuum sputtering process, oxygen with different partial pressure is introduced to form an antibacterial alloy oxide coating, the detailed description of which is as follows.

An antibacterial alloy coating composition was firstly formulated in the foregoing proportion. Thereafter, a target was prepared by a vacuum arc melting process, and before performing the vacuum arc melting process, a stainless steel substrate to be coated was washed to remove impurities on the surface of the stainless steel substrate. Subsequently, a target was prepared with the formulated antibacterial alloy coating composition, and the detailed description of the vacuum arc melting process is as described in embodiment 1, so it is not described here any more. Thereafter, the target was placed on a RF magnetron sputter and subjected to a vacuum sputtering process under oxygen with a partial pressure of 5% for film coating on the surface of the stainless steel substrate. The film coating process was preformed under an oxygen partial pressure of 5% and at a temperature of 200□, and the coating time was about 30 minutes. Thus, an antibacterial alloy oxide coating was formed on the surface of the stainless steel substrate.

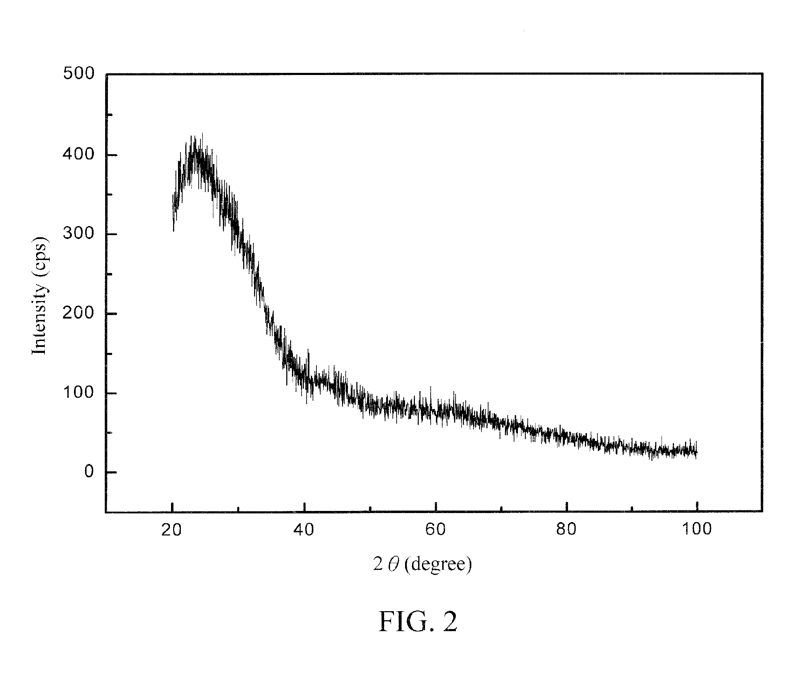

Then, an analysis for the coating property of the antibacterial alloy oxide coating was performed on the surface of the stainless steel substrate, and the result is shown in FIG. 2. FIG. 2 is an X-ray diffraction spectrum of the antibacterial alloy oxide coating in embodiment 2 of the present invention. As known from the analytical result, the antibacterial alloy oxide coating comprises a crystal structure and contains partial amorphous structure. Subsequently, the hardness of the antibacterial alloy oxide coating was tested by a pencil-scratch hardness test, and as known from the test result, the hardness of the antibacterial alloy oxide coating prepared in embodiment 2 is 8 H.

Further, the antibacterial alloy oxide coating was subjected to an antibacterial experiment. Table 3 shows the antibacterial antimicrobial activity of the antibacterial alloy oxide coating prepared in embodiment 2 of the present invention. As known from the result of the antibacterial experiment in table 3, for *staphylococcus aureus, E. coli, Klebsiella pneumonia,* and *pseudomonas aeruginosa,* the antimicrobial activity of the antibacterial alloy oxide coating is up to 5.0, and the-antimicrobial percentage is also up to more than 99.999%. Therefore, the coating of the antibacterial alloy oxide coating composition of the present invention has a very good antibacterial effect on the surface of the device indeed.

**Table 3 Antibacterial analytical values of the antibacterial alloy oxide coating prepared in embodiment 2**

| Bacteria species | Control group Bacteria number after 24 h | Sample group Bacteria number after 24 h | antimicrobial activity | antimicrobial percentage (%) |
|---|---|---|---|---|
| *staphylococcus aureus* | 2.2 x 10⁶ | <10 | 5.29 | 99.999 |
| *E. coli* | 1.2 x 10⁶ | <10 | 5.01 | 99.999 |
| *Klebsiella pneumoniae* | 1.9 x 10⁶ | <10 | 5.14 | 99.999 |
| *pseudomonas aeruginosa* | 2 x 10⁶ | <10 | 6.11 | 99.9999 |

### Embodiment 3

In this embodiment 3, the antibacterial material in the antibacterial alloy coating composition is copper, and the metallic elements in the alloy consist of five metallic elements of iron, cobalt, chromium, nickel, and aluminum. As shown in table 1 above, the atomic percentage content of copper is 15.7%, and the atomic percentage contents of iron, cobalt, chromium, nickel, and aluminum are sequentially 15.9%, 16.1%, 15.6%, 17.6%, and 14.3%. Moreover, as shown in table 1, this embodiment further comprises minor non-metallic elements, for example, oxygen and nitrogen.

Next, the difference between embodiment 3 and embodiment 1 is only in that, when carrying out the vacuum sputtering process, nitrogen with different partial pressure is introduced to form an antibacterial alloy nitride coating, the detailed description of which is as follows. An antibacterial alloy coating composition was firstly formulated in the foregoing proportion. Thereafter, a target was prepared by a vacuum arc melting process, and before performing the vacuum arc melting process, a stainless steel substrate to be coated was washed to remove impurities on the surface of the stainless steel substrate. Subsequently, a target was prepared with the formulated antibacterial alloy coating composition, and the detailed description of the vacuum arc melting process is as described in embodiment 1, so it is not described here any more. Thereafter, the target was placed on a RF magnetron sputter and subjected to a vacuum sputtering process under nitrogen with a partial pressure of 4.7% for film coating on the surface of the stainless steel substrate. Thus, an antibacterial alloy nitride coating was formed on the surface of the stainless steel substrate.

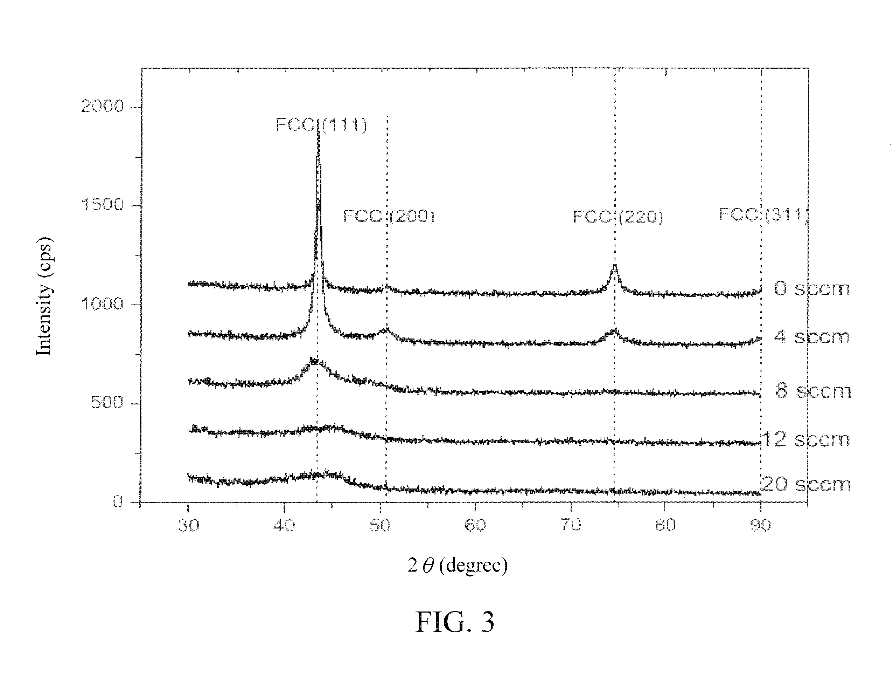

Then, an analysis for the coating property of the antibacterial alloy nitride coating was performed on the surface of the stainless steel substrate, and the result is shown in FIG 3. FIG. 3 is an X-ray diffraction spectrum of the antibacterial alloy nitride coating in embodiment 3 of the present invention. As known from the analytical result, the antibacterial alloy nitride coating comprises a FCC crystal structure and an amorphous structure. Subsequently, the hardness of the antibacterial alloy nitride coating was tested by a (indenter) hardness test, and as known from the test result, the hardness of the antibacterial alloy nitride coating prepared in embodiment 3 is 14 GPa.

Further, the antibacterial alloy nitride coating was subjected to an antibacterial experiment. As known from the result of the antibacterial experiment, for *staphylococcus aureus, E. coli, Klebsiella pneumoniae,* and *pseudomonas aeruginosa,* the-antimicrobial activity of the antibacterial alloy nitride coating is up to more than 5.0, and the antimicrobial percentage is also up to more than 99.999%. Therefore, the coating of the antibacterial alloy nitride coating composition of the present invention has a very good antibacterial effect on the surface of the device indeed.

### Embodiment 4

In this embodiment 4, the antibacterial materials in the antibacterial alloy coating composition are copper and silver, and the metallic elements in the alloy consist of six metallic elements of iron, cobalt, chromium, nickel, aluminum, and titanium. As shown in table 1 above, the atomic percentage contents of copper and silver are 0.5% and 1.2%, and the atomic percentage contents of iron, cobalt, chromium, nickel, aluminum, and titanium are sequentially 35.4%, 21.1%, 19.8%, 19.3%, 1.2%, and 1.2%. Moreover, this embodiment further comprises minor non-metallic elements, for example, oxygen (0.2%) and nitrogen (0.1 %).

An antibacterial alloy coating composition was formulated in the foregoing proportion. After the formulation was completed, a target was prepared by the vacuum arc melting process as described in embodiment 1. Then, the target was placed on a RF magnetron sputter to carry out a vacuum sputtering process for film coating on a surface of a stainless steel substrate. The detailed description of the preparation method steps is as described in embodiment 1, so it is not described here any more.

Then, the hardness of the antibacterial alloy nitride coating was tested by a (indenter) hardness test, and as known from the test result, the hardness of the antibacterial alloy oxide coating prepared in embodiment 4 is 10 GPa. Further, the antibacterial alloy nitride coating was subjected to an antibacterial experiment, and as known from the result of the antibacterial experiment, for *staphylococcus aureus, E. coli, Klebsiella pneumoniae,* and *pseudomonas aeruginosa,* the antimicrobial activity) of the antibacterial alloy nitride coating is up to more than 5.0, and the-antimicrobial percentage is also up to more than 98.6%. Therefore, the coating of the antibacterial alloy nitride coating composition of the present invention has a very good antibacterial effect on the surface of the device indeed.

### Embodiment 5

In this embodiment 5, the antibacterial materials in the antibacterial alloy coating composition are copper and silver, and the metallic elements in the alloy consist of five metallic elements of iron, cobalt, chromium, nickel, and titanium. As shown in table 1 above, the atomic percentage contents of copper and silver are 6.5% and 9.5%, and the atomic percentage contents of iron, cobalt, chromium, nickel, and titanium are sequentially 34.5%, 10.1%, 14.2%, 14.3%, and 10.5%. Moreover, this embodiment further comprises minor non-metallic elements, for example, oxygen (0.3%) and nitrogen (0.1%).

An antibacterial alloy coating composition was formulated in the foregoing proportion. After the formulation was completed, a target was prepared by the vacuum arc melting process as described in embodiment 1. Then, the target was placed on a RF magnetron sputter and subjected to a vacuum sputtering process for film coating on a surface of a stainless steel substrate. The detailed description of the preparation method steps is as described in embodiment 1, so it is not described here any more.

Further, the antibacterial alloy nitride coating was subjected to an antibacterial experiment, and as known from the result of the antibacterial experiment, for *staphylococcus aureus, E. coli, Klebsiella pneumoniae,* and *pseudomonas aeruginosa,* the antimicrobial percentage of the antibacterial alloy nitride coating is also up to more than 99.6%. Therefore, the coating of the antibacterial alloy nitride coating composition of the present invention has a very good antibacterial effect on the surface of the device indeed.

### Embodiment 6

In this embodiment 6, the antibacterial material in the antibacterial alloy coating composition is copper, the metallic elements in the alloy consist of seven metallic elements of iron, cobalt, chromium, nickel, aluminum, vanadium etc., and the non-metallic element is boron. As shown in table 1 above, the atomic percentage content of copper is 10.2%, and the atomic percentage contents of iron, cobalt, chromium, nickel, aluminum, vanadium, and boron are sequentially 21.1 %, 0.5%, 27.7%, 28.4%, 5.6%, 0.5%, and 5.6%. Moreover, this embodiment further comprises minor non-metallic elements, for example, oxygen (0.2%) and nitrogen (0.2%).

An antibacterial alloy coating composition was formulated in the foregoing proportion. After the formulation was completed, a target was prepared by the vacuum arc melting process as described in embodiment 1. Then, the target was placed on a RF magnetron sputter to carry out a vacuum sputtering process for film coating on a surface of a stainless steel substrate. The detailed description of the preparation method steps is as described in embodiment 1, so it is not described here any more.

Further, the antibacterial alloy nitride coating was subjected to an antibacterial experiment, and as known from the result of the antibacterial experiment, for *staphylococcus aureus, E. coli, Klebsiella pneumoniae,* and *pseudomonas aeruginosa,* the antimicrobial percentage of the antibacterial alloy nitride coating is also up to more than 99.99%. Therefore, the coating of the antibacterial alloy nitride coating composition of the present invention has a very good antibacterial effect on the surface of the device indeed.

### Embodiment 7

In this embodiment 7, the antibacterial materials in the antibacterial alloy coating composition are copper and silver, the metallic elements in the alloy consist of seven metallic elements of iron, cobalt, chromium, nickel, aluminum, vanadium etc., and the non-metallic element is boron. As shown in table 1 above, the atomic percentage contents of copper and silver are 2.3% and 13.9%, and the atomic percentage contents of iron, cobalt, chromium, nickel, aluminum, vanadium, and boron are sequentially 33.5%, 6.7%, 0.6%, 16.7%, 6.9%, 8.9%, and 10.2%. Moreover, this embodiment further comprises minor non-metallic elements, for example, oxygen (0.2%) and nitrogen (0.1 %).

An antibacterial alloy coating composition was formulated in the foregoing proportion. After the formulation was completed, a target was prepared by the vacuum arc melting process as described in embodiment 1. Then, the target was placed on a RF magnetron sputter to carry out a vacuum sputtering process for film coating on a surface of a stainless steel substrate. The detailed description of the preparation method steps is as described in embodiment 1, so it is not described here any more.

Further, the antibacterial alloy nitride coating was subjected to an antibacterial experiment. As known from the result, for *staphylococcus aureus, E. coli, Klebsiella pneumoniae,* and *pseudomonas aeruginosa,* the antimicrobial percentage of the antibacterial alloy nitride coating is also up to more than 99.2%. Therefore, the coating of the antibacterial alloy nitride coating composition of the present invention has a very good antibacterial effect on the surface of the device indeed.

### Embodiment 8

In this embodiment 8, the antibacterial material in the antibacterial alloy coating composition is copper, the metal alloys in the alloy consist of seven metallic elements of iron, cobalt, chromium, nickel, aluminum, vanadium etc., and the non-metallic element is boron. As shown in table 1 above, the atomic percentage content of copper is 5.4%, and the atomic percentage contents of iron, cobalt, chromium, nickel, aluminum, vanadium, and boron are sequentially 18.7%, 1.2%, 25.4%, 0.7%, 16.5%, 15.4%, and 16.4%. Moreover, this embodiment further comprises minor non-metallic elements, for example, oxygen (0.2%) and nitrogen (0.1%).

An antibacterial alloy coating composition was formulated in the foregoing proportion. After the formulation was completed, a target was prepared by the vacuum arc melting process as described in embodiment 1. Then, the target was placed on a RF magnetron sputter to carry out a vacuum sputtering process for film coating on a surface of a stainless steel substrate. The detailed description of the preparation method steps is as described in embodiment 1, so it is not described here any more.

Further, the antibacterial alloy nitride coating was subjected to an antibacterial experiment, and as known from the result, for *staphylococcus aureus, E. coli, Klelisiella pneumoniae,* and *pseudomonas aeruginosa,* the antimicrobial percentage of the antibacterial alloy nitride coating is also up to more than 99.9%. Therefore, the coating of the antibacterial alloy nitride coating composition of the present invention has a very good antibacterial effect on the surface of the device indeed.

### Embodiment 9

In this embodiment 9, the antibacterial materials in the antibacterial alloy coating composition are copper and silver, the metal alloys in the alloy consist of five metallic elements of iron, aluminum, vanadium, titanium etc., and the non-metallic element is boron. As shown in table 1 above, the atomic percentage contents of copper and silver are 25.6% and 0.6%, and the atomic percentage contents of iron, aluminum, vanadium, titanium, and boron are sequentially 34.4%, 22.5%, 1.5%, 14.5%, and 0.6%. Moreover, this embodiment further comprises minor non-metallic elements, for example, oxygen (0.2%) and nitrogen (0.1%).

An antibacterial alloy coating composition was formulated in the foregoing proportion. After the formulation was completed, a target was prepared by the vacuum arc melting process as described in embodiment 1. Then, the target was placed on a RF magnetron sputter to carry out a vacuum sputtering process for film coating on a surface of a stainless steel substrate. The detailed description of the preparation method steps is as described in embodiment 1, so it is not described here any more.

Further, the antibacterial alloy nitride coating was subjected to an antibacterial experiment, and for *staphylococcus aureus, E. coli, Klebsiella pneumoniae,* and *pseudomonas aeruginosa,* the antimicrobial percentage of the antibacterial alloy nitride coating is also up to more than 99.999%. Therefore, the coating of the antibacterial alloy nitride coating composition of the present invention has a very good antibacterial effect on the surface of the device indeed.

### Embodiment 10

In this embodiment 10, the antibacterial materials in the antibacterial alloy coating composition are copper and silver, the metallic elements in the alloy consist of four metallic elements of iron, cobalt, chromium, and aluminum, and the alloy further comprises non-metallic elements, for example, oxygen and nitrogen. As shown in table 1 above, the atomic percentage contents of copper and silver are 24.5% and 2.3%, and the atomic percentage contents of iron, cobalt, chromium, and aluminum are sequentially 20.5%, 5.6%, 7.5%, and 31.6%.

An antibacterial alloy coating composition was formulated in the foregoing proportion. After the formulation was completed, a target was prepared by the vacuum arc melting process as described in embodiment 1. Then, the target was placed on a RF magnetron sputter and subjected to a vacuum sputtering process under oxygen with a partial pressure of 7.9% and nitrogen with a partial pressure of 0.1%, for film coating on a surface of a stainless steel substrate. The detailed description of the preparation method steps is as described in embodiment 1, so it is not described here any more.

Further, the antibacterial alloy nitride coating was subjected to an antibacterial experiment. For *staphylococcus aureus, E. coli, Klebsiella pneumoniae,* and *pseudomonas aeruginosa,* the antimicrobial percentage of the antibacterial alloy nitride coating is also up to more than 99.999%. Therefore, the coating of the antibacterial alloy nitride coating composition of the present invention has a very good antibacterial effect on the surface of the device indeed.

As known from the experiment results described above, utilizing the antibacterial alloy coating prepared from the antibacterial alloy coating composition of the present invention, the results of the antibacterial experiments show that, for *staphylococcus aureus, E. coli, Klebsiella pneumoniae,* and *pseudomonas aeruginosa,* the antimicrobial activity of the antibacterial alloy coating is up to 5.2, and the antimicrobial percentage is also up to more than 99.6%. Therefore, the coating of the antibacterial alloy nitride coating composition of the present invention has a very good antibacterial effect on the surface of the device indeed. Further, the hardness of the antibacterial alloy coating prepared from the antibacterial alloy coating composition of the present invention may be also up to more than 10 Gpa. Therefore, utilizing the improved antibacterial property of the special formulations of the present invention, the hardness of these devices can be changed, and further the antibacterial effect on the surfaces of the devices can be increased significantly, thereby enhancing the application of the devices.

## Claims

1. An antibacterial alloy coating composition, comprising:
an antibacterial material, which is selected from a group consisting of copper, silver, and a mixture thereof, wherein the atomic percentage content of the antibacterial material is 1.7% to 26.8% of the total content; and
an alloy, which consists of at least more than four metallic elements and at least one non-metallic element, wherein these metallic elements are selected from a group consisting of iron, cobalt, chromium, nickel, aluminum, vanadium, and titanium, and the non-metallic element is selected from a group consisting of boron, oxygen, and nitrogen.

2. The antibacterial alloy coating composition according to claim 1, wherein the atomic percentage content of the alloy is 73.2% to 98.3% of the total content.

3. The antibacterial alloy coating composition according to claim 2, wherein the atomic percentage content of the metallic elements is 65.2% to 98% of the total content.

4. The antibacterial alloy coating composition according to claim 2, wherein the atomic percentage content of the non-metallic element is 0.3% to 16.7% of the total content.

5. The antibacterial alloy coating composition according to claim 1, wherein the antibacterial alloy coating comprises a face-centered cubic (FCC) crystal structure.

6. The antibacterial alloy coating composition according to claim 5, wherein the antibacterial alloy coating further comprises an amorphous structure.

7. The antibacterial alloy coating composition according to claim 1, wherein the thickness of the antibacterial alloy coating is 10 nm to 2,000 nm.

## Amended claims

### Amended claims in accordance with Rule 137(2) EPC.

**1.** An antibacterial alloy coating composition, comprising:
an antibacterial material, which is selected from a group consisting of copper, silver, and a mixture thereof, wherein the atomic percentage content of the antibacterial material is 1.7% to 26.8% of the total content; and
an alloy, which consists of at least more than four metallic elements and at least one non-metallic element, wherein these metallic elements are selected from a group consisting of iron, cobalt, chromium, nickel, aluminum, vanadium, and titanium, and the non-metallic element is selected from a group consisting of boron, oxygen, and nitrogen
wherein the atomic percentage content of the alloy is 73.2% to 98.3% of the total content, the atomic percentage content of the metallic elements is 65.2% to 98% of the total content, and the atomic percentage content of the non-metallic element is 0.3% to 16.7% of the total content.

**2.** The antibacterial alloy coating composition according to claim 1, wherein the antibacterial alloy coating comprises a face-centered cubic (FCC) crystal structure.

**3.** The antibacterial alloy coating composition according to claim 2, wherein the antibacterial alloy coating further comprises an amorphous structure.

**4.** The antibacterial alloy coating composition according to claim 1, wherein the thickness of the antibacterial alloy coating is 10 nm to 2,000 nm.
